# EUROPEAN PATENT SPECIFICATION

(11) **EP 2 385 970 B1**
(45) Date of publication and mention of the grant of the patent: **01.03.2017**
(21) Application number: 09837247.7
(22) Date of filing: 06.01.2009
(51) Int. Cl.: C08L 63/00, C08K 3/22, C08K 5/56, C09D 163/02, C09J 163/02, C08K 3/00

(54) **METAL STABILIZERS FOR EPOXY RESINS**
METALLSTABILISATOREN FÜR EPOXIDHARZE
STABILISANTS MÉTALLIQUES POUR RÉSINES ÉPOXYDES

(43) Date of publication of application: 16.11.2011
(73) Proprietor: Blue Cube IP LLC, Midland MI 48674 (US)
(72) Inventor: AOYAMA, Tomoyuki, Nishikoujiya Tokyo 144-0034 (JP); GONG, Frank, Y., Shanghai 201100 (CN); HOEVEL, Bernd, Shinzheim BW 76547 (DE); MULLINS, Michael, J., Houston TX 77030 (US); REN, Perrin, Shaoping, Guangdong 510650 (CN); STORER, Joey, W., Midland MI 48640 (US); SUE, Hung-Jue, College Station TX 77845 (US); VALETTE, Ludovic, Shanghai 201702 (CN); WORKU, Anteneh, Z., Pearland TX 77584 (US); THIBAULT, Raymond, J., Lake Jackson, TX 77566 (US)
(74) Representative: Bumke, Jakob Wenzel
(86) International application number: PCT/CN2009/000013
(87) International publication number: WO 2010/078688

(56) References cited:
- EP-A2- 0 375 980
- WO-A1-2008/144252
- CN-A- 1 074 919
- CN-A- 1 075 727
- US-A- 4 975 319
- US-A- 5 721 323
- DATABASE CA [Online] CHEMICAL ABSTRACTS SERVICE, COLUMBUS, OHIO, US; 26 June 1997 (1997-06-26), KITANO, RYUICHIRO: "Epoxy resin-based compositions with good solder-crack and moisture resistances and bonding property to lead frames for sealing semiconductors", XP002734488, retrieved from STN Database accession no. 1997:396626 -& JP H91 24904 A (SUMITOMO BAKELITE CO., LTD., JAPAN) 13 May 1997 (1997-05-13)

## Description

### FIELD OF THE INVENTION

Embodiments disclosed herein relate to epoxy compositions useful in electrical laminates. More specifically, embodiments disclosed herein relate to epoxy compositions with stabilizers comprising metal containing compounds useful in electrical laminates.

### BACKGROUND OF THE INVENTION

Thermosettable materials useful in high-performance electrical applications, such as high-performance circuit boards, must meet a set of demanding property requirements. For example, such materials optimally have good high-temperature properties such as high glass transition temperatures (e.g., above 200°C) and low water absorption at elevated temperature (e.g., less than 0.5% water absorption). The components used in the thermoset formulation materials must also exhibit stable solubility in organic solvents, such as acetone, 2-butanone, or cyclohexanone, as the preparation of electrical laminates conventionally involves impregnation of a fiber (such as glass) web with a solution of the thermosettable resin to form prepregs. The wetted fiber web is passed through a ventilated oven called a treater to remove the solvent and partially cure ('B-stage) the thermoset. The impregnated web that emerges from the treater is called a prepreg. Typically, treater conditions are chosen such that the glass transition temperature (Tg) of the B-staged resin is above room temperature so that the prepreg is not sticky. Conversion of prepreg to composite parts requires stacking one or more prepreg sheets, followed by heating under pressure to complete the curing process ('C-stage'). During C-staging, the resin must flow sufficiently to eliminate voids but not so much that a large amount of resin is lost at the edges of the web., The resin flow during the C-stage process can be controlled somewhat with temperature and pressure setpoints, but the ideal resin has a wide temperature range of processable viscosity (a wide "processing window").

Epoxy resins are one of the most widely used engineering resins, and are well-known for their use in composites, including electrical laminates. Epoxy resins have been used as materials for electrical/electronic equipment, such as materials for electrical laminates because of their superiority in heat resistance, chemical resistance, insulation property, dimensional stability, adhesiveness and the like.

For a variety of applications, especially for components of electrical and electronic devices, flame retardants must be added to the formulations to reduce the chance of fire in the event of an electrical failure. Brominated flame retardants currently dominate the market.

With the advent of lead-free solder regulations, the temperature to which electrical laminates are exposed has increased by about 20-40°C to 230-260°C. At these temperatures typical brominated resins are unstable, and may not be suited for lead-free solder applications. Accordingly, there exists a need to achieve thermal stability in epoxy resins while still maintaining toughness and processability.

### SUMMARY OF THE INVENTION

In an embodiment of the invention, there is disclosed a composition comprising, consisting of, or consisting essentially of: a) an epoxy resin; b) a hardener; and c) a stabilizer comprising a metal-containing compound, wherein said metal-containing compound is zinc dimethyldithiocarbamate, wherein the composition is prepared from a halogen-containing compound.

### BRIEF DESCRIPTION OF THE FIGURE

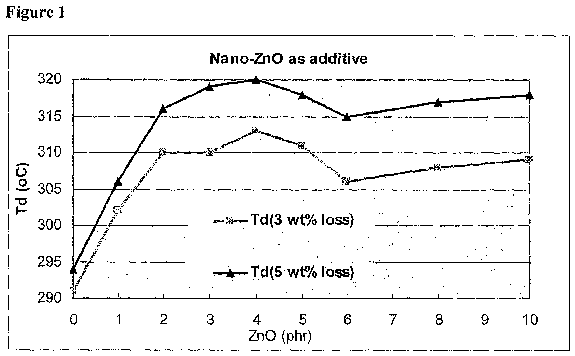

Figure 1 is a plot of phr of zinc oxide vs. the T_{d} for the nano-zinc oxide formulations.

### DETAILED DESCRIPTION OF THE INVENTION

In an embodiment of the invention, there is disclosed a composition comprising, consisting of, or consisting essentially of: a) an epoxy resin; b) a hardener; and c) a stabilizer comprising a metal-containing compound, wherein said metal-containing compound is zinc dimethyldithiocarbamate, wherein the composition is prepared from a halogen-containing compound.

The epoxy resins used in embodiments disclosed herein can vary and include conventional and commercially available epoxy resins, which can be used alone or in combinations of two or more, including, for example, novolac resins and isocyanate modified epoxy resins, among others. In choosing epoxy resins for compositions disclosed herein, consideration should not only be given to properties of the final product, but also to viscosity and other properties that may influence the processing of the resin composition.

The epoxy resin component can be any type of epoxy resin useful in molding compositions, including any material containing one or more reactive oxirane groups, referred to herein as "epoxy groups" or "epoxy functionality." Epoxy resins useful in embodiments disclosed herein can include mono-functional epoxy resins, multi- or polyfunctional epoxy resins, and combinations thereof. Monomeric and polymeric epoxy resins can be aliphatic, cycloaliphatic, aromatic, or heterocyclic epoxy resins. The polymeric epoxies include linear polymers having terminal epoxy groups (a diglycidyl ether of a polyoxyalkylene glycol, for example), polymer skeletal oxirane units (polybutadiene polyepoxide, for example) and polymers having pendant epoxy groups (such as a glycidyl methacrylate polymer or copolymer, for example). The epoxies may be pure compounds, but are generally mixtures or compounds containing one, two or more epoxy groups per molecule. In an embodiment, the epoxy resin is prepared from a halogen-containing compound. Typically, the halogen is bromine. In some embodiments, epoxy resins can also include reactive -OH groups, which can react at higher temperatures with anhydrides, organic acids, amino resins, phenolic resins, or with epoxy groups (when catalyzed) to result in additional crosslinking. In an embodiment, the epoxy resin is produced by contacting a glycidyl ether with a bisphenol compound, such as, for example, bisphenol A or tetrabromobisphenol A to form epoxy-terminated oligomers. In another embodiment, the epoxy resins can be advanced by reaction with isocyanates to form oxazolidinones. Suitable oxazolidinones include toluene diisocyanate and methylene diisocyanate (MDI or methylene bis(phenylene isocyanate)).

The composition of the present invention can also be modified by addition of other thermosets and thermoplastics. Examples of other thermosets include but are not limited to cyanates, triazines, maleimides, benzoxazines, allylated phenols, and acetylenic compounds. Examples of thermoplastics include poly(aryl ethers) such as polyphenylene oxide, poly(ether sulfones), poly(ether imides) and related materials.

In general, the epoxy resins can be glycidylated resins, cycloaliphatic resins, epoxidized oils, and so forth. The glycidated resins are frequently the reaction product of a glycidyl ether, such as epichlorohydrin, and a bisphenol compound such as bisphenol A; C₄ to C₂₈ alkyl glycidyl ethers; C₂ to C₂₈ alkyl-and alkenyl-glycidyl esters; C₁ to C₂₈ alkyl-, mono- and poly-phenol glycidyl ethers; polyglycidyl ethers of polyvalent phenols, such as pyrocatechol, resorcinol, hydroquinone, 4,4'-dihydroxydiphenyl methane (or bisphenol F), 4,4'-dihydroxy-3,3'-dimethyldiphenyl methane, 4,4'-dihydroxydiphenyl dimethyl methane (or bisphenol A), 4,4'-dihydroxydiphenyl methyl methane, 4,4'-dihydroxydiphenyl cyclohexane, 4,4'-dihydroxy-3,3'-dimethyldiphenyl propane, 4,4'-dihydroxydiphenyl sulfone, and tris(4-hydroxyphynyl)methane; polyglycidyl ethers of the chlorination and bromination products of the above-mentioned diphenols; polyglycidyl ethers of novolacs; polyglycidyl ethers of diphenols obtained by esterifying ethers of diphenols obtained by esterifying salts of an aromatic hydrocarboxylic acid with a dihaloalkane or dihalogen dialkyl ether; polyglycidyl ethers of polyphenols obtained by condensing phenols and long-chain halogen paraffins containing at least two halogen atoms. Other examples of epoxy resins useful in embodiments disclosed herein include bis-4,4'-(1-methylethylidene) phenol diglycidyl ether and (chloromethyl) oxirane bisphenol A diglycidyl ether.

In some embodiments, the epoxy resin can include glycidyl ether type; glycidyl-ester type; alicyclic type; heterocyclic type, and halogenated epoxy resins, etc. Non-limiting examples of suitable epoxy resins can include cresol novolac epoxy resin, phenolic novolac epoxy resin, biphenyl epoxy resin, hydroquinone epoxy resin, stilbene epoxy resin, and mixtures and combinations thereof.

Suitable polyepoxy compounds can include resorcinol diglycidyl ether (1,3-bis-(2,3-epoxypropoxy)benzene), diglycidyl ether of bisphenol A (2,2-bis(p-(2,3-epoxypropoxy)phenyl)propane), triglycidyl p-aminophenol (4-(2,3-epoxypropoxy)-N,N-bis(2,3-epoxypropyl)aniline), diglycidyl ether of bromobispehnol A (2,2-bis(4-(2,3-epoxypropoxy)3-bromo-phenyl)propane), diglydicylether of bisphenol F (2,2-bis(p-(2,3-epoxypropoxy)phenyl)methane), triglycidyl ether of meta- and/or para-aminophenol (3-(2,3-epoxypropoxy)N,N-bis(2,3-epoxypropyl)aniline), and tetraglycidyl methylene dianiline (N,N,N',N'-tetra(2,3-epoxypropyl) 4,4'-diaminodiphenyl methane), and mixtures of two or more polyepoxy compounds. A more exhaustive list of useful epoxy resins found can be found in Lee, H. and Neville, K., Handbook of Epoxy Resins, McGraw-Hill Book Company, 1982 reissue.

Other suitable epoxy resins include polyepoxy compounds based on aromatic amines and epichlorohydrin, such as N,N'-diglycidyl-aniline; N,N'-dimethyl-N,N'-diglycidyl-4,4'-diaminodiphenyl methane; N,N,N',N'-tetraglycidyl-4,4'-diaminodiphenyl methane; N-diglycidyl-4-aminophenyl glycidyl ether; and N,N,N',N'-tetraglycidyl-1,3-propylene bis-4-aminobenzoate. Epoxy resins can also include glycidyl derivatives of one or more of: aromatic diamines, aromatic monoprimary amines, aminophenols, polyhydric phenols, polyhydric alcohols, polycarboxylic acids.

Useful epoxy resins include, for example, polyglycidyl ethers of polyhydric polyols, such as ethylene glycol, triethylene glycol, 1,2-propylene glycol, 1,5-pentanediol, 1,2,6-hexanetriol, glycerol, and 2,2-bis(4-hydroxy cyclohexyl)propane; polyglycidyl ethers of aliphatic and aromatic polycarboxylic acids, such as, for example, oxalic acid, succinic acid, glutaric acid, terephthalic acid, 2,6-napthalene dicarboxylic acid, and dimerized linoleic acid; polyglycidyl ethers of polyphenols, such as, for example, bisphenol A, bisphenol F, 1,1-bis(4-hydroxyphenyl)ethane, 1,1-bis(4-hydroxyphenyl)isobutane, and 1,5-dihydroxy napthalene; modified epoxy resins with acrylate or urethane moieties; glycidlyamine epoxy resins; and novolac resins.

The epoxy compounds can be cycloaliphatic or alicyclic epoxides. Examples of cycloaliphatic epoxides include diepoxides of cycloaliphatic esters of dicarboxylic acids such as bis(3,4-epoxycyclohexylmethyl)oxalate, bis(3,4-epoxycyclohexylmethyl)adipate, bis(3,4-epoxy-6-methylcyclohexylmethyl)adipate, bis(3,4-epoxycyclohexylmethyl)pimelate; vinylcyclohexene diepoxide; limonene diepoxide; dicyclopentadiene diepoxide; and the like. Other suitable diepoxides of cycloaliphatic esters of dicarboxylic acids are described, for example, in U.S. Patent No. 2,750,395.

Other cycloaliphatic epoxides include 3,4-epoxycyclohexylmethyl-3,4-epoxycyclohexane carboxylates such as 3,4-epoxycyclohexyimethyl-3,4-epoxycyclohexane carboxylate; 3,4-epoxy-1-methylcyclohexyl-methyl-3,4-epoxy-1-methylcyclohexane carboxylate; 6-methyl-3,4-epoxycyclohexylmethylmethyl-6-methyl-3,4-epoxycyclohexane carboxylate; 3,4-epoxy-2-methylcyclohexylmethyl-3,4-epoxy-2-methylcyclohexane carboxylate; 3,4-epoxy-3-methylcyclohexyl-methyl-3,4-epoxy-3-methylcyclohexane carboxylate; 3,4-epoxy-5-methylcyclohexyl-methyl-3,4-epoxy-5-methylcyclohexane carboxylate and the like. Other suitable 3,4-epoxycyclohexylmethyl-3,4-epoxycyclohexane carboxylates are described, for example, in U.S. Patent No. 2,890,194.

Further epoxy-containing materials which are useful include those based on glycidyl ether monomers. Examples are di- or polyglycidyl ethers of polyhydric phenols obtained by reacting a polyhydric phenol, such as a bisphenol compound with an excess of chlorohydrin such as epichlorohydrin. Such polyhydric phenols include resorcinol, bis(4-hydroxyphenyl)methane (known as bisphenol F), 2,2-bis(4-hydroxyphenyl)propane (known as bisphenol A), 2,2-bis(4'-hydroxy-3',5'-dibromophenyl)propane, 1,1,2,2-tetrakis(4'-hydroxy-phenyl)ethane or condensates of phenols with formaldehyde that are obtained under acid conditions such as phenol novolacs and cresol novolacs. Examples of this type of epoxy resin are described in U.S. Patent No. 3,018,262. Other examples include di- or polyglycidyl ethers of polyhydric alcohols such as 1,4-butanediol, or polyalkylene glycols such as polypropylene glycol and di- or polyglycidyl ethers of cycloaliphatic polyols such as 2,2-bis(4-hydroxycyclohexyl)propane. Other examples are monofunctional resins such as cresyl glycidyl ether or butyl glycidyl ether.

Another class of epoxy compounds are polyglycidyl esters and poly(beta-methylglycidyl) esters of polyvalent carboxylic acids such as phthalic acid, terephthalic acid, tetrahydrophthalic acid or hexahydrophthalic acid. A further class of epoxy compounds are N-glycidyl derivatives of amines, amides and heterocyclic nitrogen bases such as N,N-diglycidyl aniline, N,N-diglycidyl toluidine, N,N,N',N'-tetraglycidyl bis(4-aminophenyl)methane, triglycidyl isocyanurate, N,N'-diglycidyl ethyl urea, N,N'-diglycidyl-5,5-dimethylhydantoin, and N,N'-diglycidyl-5-isopropylhydantoin.

Still other epoxy-containing materials are copolymers of acrylic acid esters of glycidol such as glycidylacrylate and glycidylmethacrylate with one or more copolymerizable vinyl compounds. Examples of such copolymers are 1:1 styrene-glycidylmethacrylate, 1:1 methyl-methacrylateglycidylacrylate and a 62.5:24:13.5 methylmethacrylate-ethyl acrylate-glycidylmethacrylate.

Epoxy compounds that are readily available include octadecylene oxide; glycidylmethacrylate; diglycidyl ether of bisphenol A; D.E.R.™ 331 (bisphenol A liquid epoxy resin) and D.E.R.™ 332 (diglycidyl ether of bisphenol A) available from The Dow Chemical Company, Midland, Michigan; vinylcyclohexene dioxide; 3,4-epoxycyclohexylmethyl-3,4-epoxycyclohexane carboxylate; 3,4-epoxy-6-methylcyclohexyl-methyl-3,4-epoxy-6-methylcyclohexane carboxylate; bis(3,4-epoxy-6-methylcyclohexylmethyl) adipate; bis(2,3-epoxycyclopentyl) ether; aliphatic epoxy modified with polypropylene glycol; dipentene dioxide; epoxidized polybutadiene; silicone resin containing epoxy functionality; flame retardant epoxy resins (such as a brominated bisphenol type epoxy resin available under the trade names D.E.R.™ 530, 538, 539, 560, 592, and 593, available from The Dow Chemical Company, Midland, Michigan); polyglycidyl ether of phenolformaldehyde novolac (such as those available under the tradenames D.E.N.™ 431 and D.E.N.™ 438 available from The Dow Chemical Company, Midland, Michigan); and resorcinol diglycidyl ether. Although not specifically mentioned, other epoxy resins under the tradename designations D.E.R.™ and D.E.N.™ available from The Dow Chemical Company can also be used.

In an embodiment, the epoxy resin can be produced by contacting a glycidyl ether with a bisphenol compound and a polyisocyanate, such as toluene diisocyanate or 'methylene diisocyanate' (the diisocyanate of methylene dianiline), to form oxazolidinone moieties. These resins can be prepared using methods outlined in U.S. Patent No. 5,112,932, which is incorporated herein by reference.

Other suitable epoxy resins are disclosed in, for example, U.S. Patent Nos. 7,163,973, 6,632,893, 6,242,083, 7,037,958, 6,572,971, 6,153,719, and 5,405,688 and U.S. Patent Application Publication Nos. 20060293172 and 20050171237, each of which is hereby incorporated herein by reference.

Other suitable epoxy resins include phenolic resins, benzoxazine resins, aryl cyanate resins, aryl triazine resins, and a maleimide resins.

Mixtures of any of the above-listed epoxy resins may, of course, also be used.

A hardener (or curing agent) can be provided for promoting crosslinking of the composition to form a thermoset composition. The hardeners can be used individually or as a mixture of two or more. In some embodiments, hardeners can include dicyandiamide (dicy) or phenolic curing agents such as novolacs, resoles, bisphenols. Other hardeners can include advanced (oligomeric) epoxy resins, some of which are disclosed above. In an embodiment, the hardener can be prepared from a halogen-containing compound in which the halogen is typically bromine. Examples of advanced epoxy resin hardeners can include, for example, epoxy resins prepared from bisphenol A diglycidyl ether (or the diglycidyl ether of tetrabromobisphenol A) and an excess of bisphenol or (tetrabromobisphenol). Anhydrides such as poly(styrene-co-maleic anhydride) can also be used.

Hardeners can also include primary and secondary polyamines and adducts thereof, anhydrides, and polyamides. For example, polyfunctional amines may include aliphatic amine compounds such as diethylene triamine (D.E.H.™ 20, available from The Dow Chemical Company, Midland, Michigan), triethylene tetramine (D.E.H.™ 24, available from The Dow Chemical Company, Midland, Michigan), tetraethylene pentamine (D.E.H.™ 26, available from The Dow Chemical Company, Midland, Michigan), as well as adducts of the above amines with epoxy resins, diluents, or other amine-reactive compounds. Aromatic amines, such as metaphenylene diamine and diamine diphenyl sulfone, aliphatic polyamines, such as amino ethyl piperazine and polyethylene polyamine, and aromatic polyamines, such as metaphenylene diamine, diamino diphenyl sulfone, and diethyltoluene diamine, can also be used.

Anhydride hardeners can include, for example, nadic methyl anhydride, hexahydrophthalic anhydride, trimellitic anhydride, dodecenyl succinic anhydride, phthalic anhydride, methyl hexahydrophthalic anhydride, tetrahydrophthalic anhydride, and methyl tetrahydrophthalic anhydride, among others.

The hardener can include a phenol-derived or substituted phenol-derived novolac or an anhydride. Non-limiting examples of suitable hardeners include phenol novolac hardener, cresol novolac hardener, dicyclopentadiene bisphenol hardener, limonene type hardener, anhydrides, and mixtures thereof.

In some embodiments, the phenol novolac hardener can contain a biphenyl or naphthyl moiety. The phenolic hydroxy groups can be attached to the biphenyl or naphthyl moiety of the compound. This type of hardener can be prepared, for example, according to the methods described in EP915118A1. For example, a hardener containing a biphenyl moiety can be prepared by reacting phenol with bismethoxy-methylene biphenyl.

In other embodiments, hardeners may include dicyandiamide, boron trifluoride monoethylamine, and diaminocyclohexane. Hardeners may also include imidazoles, their salts, and adducts. These epoxy hardeners are typically solid at room temperature. Examples of suitable imadazole hardeners are disclosed in EP906927A1. Other hardeners include phenolic, benzoxazine, aromatic amines, amido amines, aliphatic amines, anhydrides, and phenols.

In some embodiments, the hardeners may be polyamides or an amino compound having a molecular weight up to 500 per amino group, such as an aromatic amine or a guanidine derivative. Examples of amino curing agents include 4-chlorophenyl-N,N-dimethyl-urea and 3,4-dichlorophenyl-N,N-dimethyl-urea.

Other examples of hardeners useful in embodiments disclosed herein include: 3,3'- and 4,4'-diaminodiphenylsulfone; methylenedianiline; bis(4-amino-3,5-dimethyl-phenyl)-1,4-diisopropylbenzene available as EPON 1062 from Hexion Chemical Co.; and bis(4-aminophenyl)-1,4-diisopropylbenzene available as EPON 1061 from Hexion Chemical Co.

Thiol hardeners for epoxy compounds may also be used, and are described, for example, in U.S. Patent No. 5,374,668. As used herein, "thiol" also includes polythiol or polymercaptan curing agents. Illustrative thiols include aliphatic thiols such as methanedithiol, propanedithiol, cyclohexanedithiol, 2-mercaptoethyl-2,3-dimercapto-succinate, 2,3-dimercapto-1-propanol(2-mercaptoacetate), diethylene glycol bis(2-mercaptoacetate), 1,2-dimercaptopropyl methyl ether, bis(2-mercaptoethyl)ether, trimethylolpropane tris(thioglycolate), pentaerythritol tetra(mercaptopropionate), pentaerythritol tetra(thioglycolate), ethyleneglycol dithioglycolate, trimethylolpropane tris(beta-thiopropionate), tris-mercaptan derivative of tri-glycidyl ether of propoxylated alkane, and dipentaerythritol poly(beta-thiopropionate); halogen-substituted derivatives of the aliphatic thiols; aromatic thiols such as di-, tri- or tetra-mercaptobenzene, bis-, tris-or tetrakis(mercaptoalkyl)benzene, dimercaptobiphenyl, toluenedithiol and naphthalenedithiol; halogen-substituted derivatives of the aromatic thiols; heterocyclic ring-containing thiols such as amino-4,6-dithiol-sym-triazine, alkoxy-4,6-dithiol-sym-triazine, aryloxy-4,6-dithiol-sym-triazine and 1,3,5-tris(3-mercaptopropyl) isocyanurate; halogen-substituted derivatives of the heterocyclic ring-containing thiols; thiol compounds having at least two mercapto groups and containing sulfur atoms in addition to the mercapto groups such as bis-, tris- or tetra(mercaptoalkylthio)benzene, bis-, tris- or tetra(mercaptoalkylthio)alkane, bis(mercaptoalkyl) disulfide, hydroxyalkylsulfidebis(mercaptopropionate), hydroxyalkylsulfidebis(mercaptoacetate), mercaptoethyl ether bis(mercaptopropionate), 1,4-dithian-2,5-diolbis(mercaptoacetate), thiodiglycolic acid bis(mercaptoalkyl ester), thiodipropionic acid bis(2-mercaptoalkyl ester), 4,4-thiobutyric acid bis(2-mercaptoalkyl ester), 3,4-thiophenedithiol, bismuththiol and 2,5-dimercapto-1,3,4-thiadiazol.

The hardener can also be a nucleophilic substance such as an amine, a tertiary phosphine, a quaternary ammonium salt with a nucleophilic anion, a quaternary phosphonium salt with a nucleophilic anion, an imidazole, a tertiary arsenium salt with a nucleophilic anion, and a tertiary sulfonium salt with a nucleophilic anion.

Aliphatic polyamines that are modified by adduction with epoxy resins, acrylonitrile, or methacrylates may also be utilized as curing agents. In addition, various Mannich bases can be used. Aromatic amines wherein the amine groups are directly attached to the aromatic ring may also be used.

Quaternary ammonium salts with a nucleophilic anion useful as a hardener in embodiments disclosed herein can include tetraethyl ammonium chloride, tetrapropyl ammonium acetate, hexyl trimethyl ammonium bromide, benzyl trimethyl ammonium cyanide, cetyl triethyl ammonium azide, N,N-dimethylpyrrolidinium isocyanate, N-methylpyrridinium phenolate, N-methyl-o-chloropyrridinium chloride, methyl viologen dichloride and the like.

The suitability of the hardener for use herein can be determined by reference to manufacturer specifications or routine experimentation. Manufacturer specifications can be used to determine if the curing agent is an amorphous solid or a crystalline solid at the desired temperatures for mixing with the liquid or solid epoxy. Alternatively, the solid curing agent can be tested using differential scanning calorimetry (DSC) to determine the amorphous or crystalline nature of the solid curing agent and the suitability of the curing agent for mixing with the resin composition in either liquid or solid form.

Mixtures of one or more of the above described epoxy hardeners (or curing agents) can also be used.

The stabilizer can have any suitable particle size. In an embodiment, the particles can be on a micro or nano scale.

While not wishing to be bound by theory, it is believed that the metal-containing compound forms a dative bond with a source of nucleophilic nitrogen in the composition. A dative bond (also known as a coordinate covalent bond) is a description of bonding between two atoms (ie. a metal and a ligand) in which both electrons shared in the bond come from the same atom. The decomposition temperature (Td) of brominated thermosets is a negative square function (inverse parabola) to the concentration of imidazole (used as a catalyst), dicy (dicyandiamide used as a hardener), and oxazolidinone (the backbone of several resins). Replacement of dicyandiamide with phenolic curing agents results in a slower rate of bromine/HBr loss, and therefore a higher Td. The metal compounds of the disclosed embodiments form complexes with dicy, and therefore slow the rate of decomposition of brominated epoxies cured with dicy. Examples of nucleophilic nitrogen sources include but are not limited to an imidazole, an oxazolidinone, dicyandiamide and combinations thereof.

The stabilizer can be generally present in an amount in the range of from 0.1 weight percent to 20 weight percent, based on the total weight of the composition.

Optionally, catalysts can be added to the compositions described above. Catalysts can include, but are not limited to, imidazole compounds including compounds having one imidazole ring per molecule, such as imidazole, 2-methylimidazole, 2-ethyl-4-methylimidazole, 2-undecylimidazole, 2-heptadecylimidazole, 2-phenylimidazole, 2-phenyl-4-methylimidazole, 1-benzyl-2-methylimidazole, 2-ethylimidazole, 2-isopropylimidazole, 2-phenyl-4-benzylimidazole, 1-cyanoethyl-2-methylimidazole, 1-cyanoethyl-2-ethyl-4-methylimidazole, 1-cyanoethyl-2-undecylimidazole, 1-cyanoethyl-2-isopropylimidazole, 1-cyanoethyl-2-phenylimidazole, 2,4-diamino-6-[2'-methylimidazolyl-(1)']-ethyl-s-triazine, 2,4-diamino-6-[2'-ethyl-4-methylimidazolyl-(1)']-ethyl-s-triazine, 2,4-diamino-6-[2'-undecylimidazolyl-(1)']-ethyl-s-triazine, 2-methyl-imidazo-lium-isocyanuric acid adduct, 2-phenylimidazolium-isocyanuric acid adduct, 1-aminoethyl-2-methylimidazole, 2-phenyl-4,5-dihydroxymethylimidazole, 2-phenyl-4-methyl-5-hydroxymethylimidazole, 2-phenyl-4-benzyl-5-hydroxymethylimidazole and the like; and compounds containing 2 or more imidazole rings per molecule which are obtained by dehydrating above-named hydroxymethyl-containing imidazole compounds such as 2-phenyl-4,5-dihydroxymethylimidazole, 2-phenyl-4-methyl-5-hydroxymethylimidazole and 2-phenyl-4-benzyl-5-hydroxy-methylimidazole; and condensing them with formaldehyde, e.g., 4,4'-methylene-bis-(2-ethyl-5-methylimidazole), and the like.

In other embodiments, suitable catalysts can include amine catalysts such as N-alkylmorpholines, N-alkylalkanolamines, N,N-dialkylcyclohexylamines, and alkylamines where the alkyl groups are methyl, ethyl, propyl, butyl and isomeric forms thereof, and heterocyclic amines.

Non-amine catalysts can also be used. Organometallic compounds of bismuth, lead, tin, titanium, iron, antimony, uranium, cadmium, cobalt, thorium, aluminum, mercury, zinc, nickel, cerium, molybdenum, vanadium, copper, manganese, and zirconium, may be used. Illustrative examples include bismuth nitrate, lead 2-ethylhexoate, lead benzoate, ferric chloride, antimony trichloride, stannous acetate, stannous octoate, and stannous 2-ethylhexoate. Other catalysts that can be used are disclosed in, for example, PCT Publication No. WO 00/15690, which is incorporated by reference in its entirety.

In some embodiments, suitable catalysts can include nucleophilic amines and phosphines, especially nitrogen heterocycles such as alkylated imidazoles: 2-phenyl imidazole, 2-methyl imidazole, 1-methyl imidazole, 2-methyl-4-ethyl imidazole; other heterocycles such as diazabicycloundecene (DBU), diazabicyclooctene, hexamethylenetetramine, morpholine, piperidine; trialkylamines such as triethylamine, trimethylamine, benzyldimethyl amine; phosphines such as triphenylphosphine, tritolylphosphine, triethylphosphine; quaternary salts such as triethylammonium chloride, tetraethylammonium chloride, tetraethylammonium acetate, triphenylphosphonium acetate, and triphenylphosphonium iodide. Mixtures of one or more of the above described catalysts can also be used.

Another component, which can be added to the composition, is a solvent or a blend of solvents. The solvent used in the epoxy resin composition can be miscible with the other components in the resin composition. The solvent used can be selected from those typically used in making electrical laminates. Examples of suitable solvents employed in the present invention include, for example, ketones, ethers, acetates, aromatic hydrocarbons, cyclohexanone, dimethylformamide, glycol ethers, and combinations thereof.

Solvents for the catalyst and the inhibitor may include polar solvents. Lower alcohols having from 1 to 20 carbon atoms, such as, for example, methanol, provide good solubility and volatility for removal from the resin matrix when prepregs are formed. Other useful solvents can include, for example, acetone, methyl ethyl ketone, DOWANOL™ PMA, DOWANOL™ PM, N,-methyl-2-pyrrolidone, dimethylsul sulfoxide, dimethylformamide, tetrahydrofuran, 1, 2-propane diol, ethylene glycol and glycerine.

The total amount of solvent used in the composition generally ranges from about 0.5 to about 95 weight percent in some embodiments. In other embodiments, the total amount of solvent can range from 2 to 60 weight percent; from 3 to 50 weight percent in other embodiments; and from 5 to 40 weight percent in yet other embodiments. Mixtures of one or more of the above described solvents can also be used.

The composition also contains a halogen containing compound. Generally, the halogen containing compound is a halogenated flame retardant, including brominated flame retardants. Specific examples of brominated additives include brominated polyphenols such as tetrabromobisphenol A (TBBA) and tetrabromobisphenol F and materials derived therefrom: TBBA-diglycidyl ether, reaction products of bisphenol A or TBBA with TBBA-diglycidyl ether, and reaction products of bisphenol A diglycidyl ether with TBBA. Mixtures of one or more of the above described flame retardant additives can also be used.

The compositions disclosed herein can optionally include synergists, and conventional additives and inert fillers. Synergists can include, for example, magnesium hydroxide, zinc borate, and metallocenes), solvents (e.g., acetone, methyl ethyl ketone, and DOWANOL™ PMA). Additives and inert fillers may include, for example, silica, alumina, glass, talc, metal powders, titanium dioxide, wetting agents, pigments, coloring agents, mold release agents, coupling agents, ion scavengers, UV stabilizers, flexibilizing agents, and tackifying agents. Additives and fillers can also include fumed silica, aggregates such as glass beads, polytetrafluoroethylene, polyol resins, polyester resins, phenolic resins, graphite, molybdenum disulfide, abrasive pigments, viscosity reducing agents, boron nitride, mica, nucleating agents, and stabilizers, among others. Fillers can include functional or non-functional particulate fillers that may have a particle size ranging from 0.5 nm to 100 microns and may include, for example, alumina trihydrate, aluminum oxide, aluminum hydroxide oxide, metal oxides, and nano tubes). Fillers and modifiers can be preheated to drive off moisture prior to addition to the epoxy resin composition. Additionally, these optional additives can have an effect on the properties of the composition, before and/or after curing, and should be taken into account when formulating the composition and the desired reaction product. Silane treated fillers can be used.

In other embodiments, compositions disclosed herein can include toughening agents. Toughening agents function by forming a secondary phase within the polymer matrix. This secondary phase is rubbery and hence is capable of crack growth arrestment, providing improved impact toughness. Toughening agents can include polysulfones, silicon-containing elastomeric polymers, polysiloxanes, and other rubber toughening agents known in the art.

In some embodiments, minor amounts of higher molecular weight, relatively nonvolatile monoalcohols, polyols, and other epoxy- or isocyanato-reactive diluents may be used, if desired, to serve as plasticizers in the curable and thermoset compositions disclosed herein. For example, isocyanates, isocyanurates, cyanate esters, allyl containing molecules or other ethylenically unsaturated compounds, and acrylates may be used in some embodiments. Exemplary non-reactive thermoplastic resins include polyphenylsulfones, polysulfones, polyethersolufones, polyvinylidene fluoride, polyetherimide, polypthalimide, polybenzimidiazole, acyrlics, phenoxy, and urethane. In other embodiments, compositions disclosed herein may also include adhesion promoters such as modified organosilanes (epoxidized, methacryl, amino), acetylacetonates, and sulfur containing molecules.

In yet other embodiments, compositions disclosed herein can include wetting and dispersing aids, for example, modified organosilanes, BYK W 900 series and BYK W 9010, and modified fluorocarbons. In still other embodiments, compositions disclosed herein may include air release additives, for example, BYK A530, BYKA525, BYK A555, and BYK A 560. Embodiments disclosed herein may also include surface modifiers (e.g., slip and gloss additives) and mold release agents (e.g., waxes), and other functional additives or pre-reacted products to improve polymer properties.

Some embodiments may include other co-reactants that may be incorporated to obtain specific properties of the curable and electrical laminate compositions disclosed herein. Mixtures of co-reactants and/or one or more of the above described additives can also be used.

In other embodiments, thermosetting compositions disclosed herein may include fibrous reinforcement materials, such as continuous and/or chopped fibers. The fibrous reinforcement material may include glass fibers, carbon fibers, or organic fibers such as polyamide, polyimide, and polyester. The concentration of fibrous reinforcements used in embodiments of the thermosetting compositions may be between about 1 percent to about 95 percent by weight, based on the total weight of the composition; between about 5 percent and 90 percent by weight in other embodiments; between about 10 percent and 80 percent in other embodiments; between about 20 percent and 70 percent in other embodiments; and between 30 percent and 60 percent in yet other embodiments.

In other embodiments, compositions disclosed herein may include nanofillers. Nanofillers may include inorganic, organic, or metallic, and may be in the form of powders, whiskers, fibers, plates or films. The nanofillers may be generally any filler or combination of fillers having at least one dimension (length, width, or thickness) from about 0.1 to about 100 nanometers. For example, for powders, the at least one dimension may be characterized as the grain size; for whiskers and fibers, the at least one dimension is the diameter; and for plates and films, the at least one dimension is the thickness. Clays, for example, may be dispersed in an epoxy resin-based matrix, and the clays may be broken down into very thin constituent layers when dispersed in the epoxy resin under shear. Nanofillers may include clays, organo-clays, carbon nanotubes, nanowhiskers (such as SiC), SiO₂ elements, anions, or salts of one or more elements selected from the s, p, d, and f groups of the periodic table, metals, metal oxides, and ceramics.

The concentration of any of the above described additives, when used in the thermosetting compositions described herein, may be between about 1 percent and 95 percent, based on the total weight of the composition; between 2 percent and 90 percent in other embodiments; between 5 percent and 80 percent in other embodiments; between 10 percent and 60 percent in other embodiments, and between 15 percent and 50 percent in yet other embodiments.

The proportions of components in the composition may depend, in part, upon the properties desired in the electrical laminate composition or coating or other end-use product to be produced, the desired cure response of the composition, and the desired storage stability of the composition (desired shelf life). The compositions in the above-described embodiments can be used to produce varnishes. In addition to an epoxy resin, a varnish can also contain curing agents, hardeners, and catalysts. A varnish can then be used to produce a variety of products including but not limited to prepregs, electrical laminates, coatings, composites, castings and adhesives.

In some embodiments, the epoxy resin may be present in an amount in the range from 0.1 to 99 weight percent, based on a total weight of the composition. In other embodiments, the epoxy resin may be present in the range from 5 to 90 weight percent, based on the total weight of the composition; from 10 to 80 weight percent in other embodiments; and from 10 to 50 weight percent in yet other embodiments. In other embodiments, the epoxy resin can be used in an amount in the range from 10 to 40 weight percent of the composition; and from 20 to 30 weight percent in yet other embodiments.

The proportions of other components may also depend, in part, upon the properties desired in the thermoset resins, electrical laminates, or coatings to be produced. For example, variables to consider in selecting hardeners and amounts of hardeners may include the epoxy composition (if a blend), the desired properties of the electrical laminate composition (Tg, T_{d}, flexibility, electrical properties, etc.), desired cure rates, and the number of reactive groups per catalyst molecule, such as the number of active hydrogens in an amine. In some embodiments, the amount of hardener used may vary from 0.1 to 150 parts per hundred parts epoxy resin, by weight. In other embodiments, the hardener may be used in an amount ranging from 5 to 95 parts per hundred parts epoxy resin, by weight; and the hardener may be used in an amount ranging from 10 to 90 parts per hundred parts epoxy resin, by weight, in yet other embodiments. In yet other embodiments, the amount of hardener may depend on components other than the epoxy resin.

In some embodiments, thermoset resins formed from the above described compositions may have a glass transition temperature, as measured using differential scanning calorimetry, of at least 190°C. In other embodiments, thermoset resins formed from the above described curable compositions may have a glass transition temperature, as measured using differential scanning calorimetry, of at least 200°C; at least 210°C in other embodiments; at least 220°C in other embodiments; and at least 230°C in yet other embodiments.

In some embodiments, thermoset resins formed from the above described compositions may have a 5% decomposition temperature, Td_{,} as measured using thermogravimetric analyses (TGA), of at least 300°C. In other embodiments, thermoset resins formed from the above described curable compositions may have a T_{d} as measured using TGA, of at least 320°C; at least 330°C in other embodiments; at least 340°C in other embodiments; and at least 350°C in yet other embodiments,.

In other embodiments, the curable compositions can be substantially free of particulates with improved homogeneity stability. For example, in some embodiments, the curable compositions may remain clear and homogeneous for at least 28 days in some embodiments, and at least 35 days in other embodiments, as measured by experimental analysis using a Gardner bubble viscosity tube, as detailed further below.

In some embodiments, composites can be formed by curing the compositions disclosed herein. In other embodiments, composites may be formed by applying a curable epoxy resin composition to a substrate or a reinforcing material, such as by impregnating or coating the substrate or reinforcing material to form a prepreg, and curing the prepreg under pressure to form the electrical laminate composition.

After the composition has been produced, as described above, it can be disposed on, in, or between the above described substrates, before, during, or after cure of an electrical laminate composition. For example, a composite may be formed by coating a substrate with a curable composition. Coating may be performed by various procedures, including spray coating, curtain flow coating, coating with a roll coater or a gravure coater, brush coating, and dipping or immersion coating.

In various embodiments, the substrate can be monolayer or multi-layer. For example, the substrate may be a composite of two alloys, a multi-layered polymeric article, and a metal-coated polymer, among others, for example. In other various embodiments, one or more layers of the curable composition may be disposed on a substrate. Other multi-layer composites, formed by various combinations of substrate layers and electrical laminate composition layers are also envisaged herein.

In some embodiments, the heating of the composition can be localized, such as to avoid overheating of a temperature-sensitive substrate, for example. In other embodiments, the heating may include heating the substrate and the composition.

Curing of the compositions disclosed herein may require a temperature of at least about 30°C, up to about 250°C, for periods of minutes up to hours, depending on the epoxy resin, hardener, and catalyst, if used. In other embodiments, curing can occur at a temperature of at least 100°C, for periods of minutes up to hours. Post-treatments may be used as well, such post-treatments ordinarily being at temperatures between about 100°C and 250°C.

In some embodiments, curing can be staged to prevent exotherms. Staging, for example, includes curing for a period of time at a temperature followed by curing for a period of time at a higher temperature. Staged curing may include two or more curing stages, and may commence at temperatures below about 180°C in some embodiments, and below about 150°C in other embodiments.

In some embodiments, curing temperatures can range from a lower limit of 30°C, 40°C, 50°C, 60°C, 70°C, 80°C, 90°C, 100°C, 110°C, 120°C, 130°C, 140°C, 150°C, 160°C, 170°C, or 180°C to an upper limit of 250°C, 240°C, 230°C, 220°C, 210°C, 200°C, 190°C, 180°C, 170°C, 160°C, where the range may be from any lower limit to any upper limit.

The curable compositions disclosed herein may be useful in composites containing high strength filaments or fibers such as carbon (graphite), glass, boron, and the like. Composites can contain from about 30% to about 70%, in some embodiments, and from 40% to 70% in other embodiments, of these fibers based on the total volume of the composite.

Fiber reinforced composites, for example, can be formed by hot melt prepregging. The prepregging method is characterized by impregnating bands or fabrics of continuous fiber with a thermosetting composition as described herein in molten form to yield a prepreg, which is laid up and cured to provide a composite of fiber and epoxy resin.

Other processing techniques can be used to form electrical laminate composites containing the compositions disclosed herein. For example, filament winding, solvent prepregging, and pultrusion are typical processing techniques in which the curable composition may be used. Moreover, fibers in the form of bundles can be coated with the curable composition, laid up as by filament winding, and cured to form a composite.

The curable compositions and composites described herein may be useful as adhesives, structural and electrical laminates, coatings, marine coatings, composites, powder coatings, adhesives, castings, structures for the aerospace industry, and as circuit boards and the like for the electronics industry.

In some embodiments, the curable compositions and resulting thermoset resins may be used in composites, castings, coatings, adhesives, or sealants that may be disposed on, in, or between various substrates. In other embodiments, the curable compositions may be applied to a substrate to obtain an epoxy based prepreg. As used herein, the substrates include, for example, glass cloth, a glass fiber, glass paper, paper, and similar substrates of polyethylene and polypropylene. The obtained prepreg can be cut into a desired size. An electrical conductive layer can be formed on the laminate / prepreg with an electrical conductive material. As used herein, suitable electrical conductive materials include electrical conductive metals such as copper, gold, silver, platinum and aluminum. Such electrical laminates may be used, for example, as multi-layer printed circuit boards for electrical or electronics equipment. Laminates made from the maleimide-triazine-epoxy polymer blends are especially useful for the production of HDI (high density interconnect) boards. Examples of HDI boards include those used in cell phones or those used for Interconnect (IC) substrates.

### Examples

The following examples are intended to be illustrative of the present invention and to teach one of ordinary skill in the art to make and use the invention.

### Test Methods

Glass transition temperature, Tg, is the temperature at which an amorphous solid goes from a hard, glass-like state to a rubber-like state. Tg is determined by differential scanning calorimetry (DSC) (IPC Method IPC-TM-650 2.4.25).

Thermal decomposition temperature, T_{d}, was measured by thermo-gravimetric analysis (TGA) under nitrogen, using TA Instruments Thermal Analysis - TGA 1000, with a heating ramp of 10°/minute from 40 to 400°C. T_{d} was determined at 5% weight loss for the fully cured resin films (200°C @ 90 minutes, in an oven with good ventilation) from a hot plate (171°C at 250-300 seconds). The T_{d} (5% wt loss) measurement is the temperature at which 5 weight percent of the sample is lost to decomposition products. The T_{d} (10% wt loss) is the temperature at which 10 weight percent of the sample is lost to decomposition products.

Stability data for the compositions are measured using Gardner bubble viscometers. Stability data includes viscosity and appearance; each may be measured by sealing a sample of the curable composition in a Gardner bubble tube. Stability data is measured according to AOC Method Ka 6-63, ASTM D 1131, D 1545, D 1725, and FTMS 141a Method 4272. Viscosity data is measured using the time it takes for an air bubble to rise through the sample in the Gardner bubble tube. Viscosity is classified on a scale of <A, A, B, C, and D, with <A being less viscous than D.

In the examples below, D.E.R.™ 592-A80 is a brominated epoxy resin containing oxazolidinone heterocycles at 80 wt % solids in acetone. All of the other materials were purchased from Aldrich Chemical Co. The "nano-ZnO", also from Aldrich has an average particle size of less than 100 nm. A conventional ("normal") ZnO powder was also screened for comparison. '2-MI' stands for 2-methylimidazole.

### Example 1

A 125-part quantity of D.E.R.™ 592-A80 (a brominated epoxy resin containing oxazolidinone heterocycles at 80 weight percent solids in acetone, 100 parts of solids), 36.25 parts of a dicyandiamide (8 weight percent solids in N,N-dimethylformamide (DMF)/Dowanol™ PM=50 wt%/50 wt%) were mixed and shaken for 30 minutes to give a homogeneous solution. To this solution, the metal-containing compound zinc dimethyldithiocarbamate and other reference zinc-containing stabilizers were then added. These stabilizers are shown in Table I. After the addition of the stabilizer, the mixture was shaken vigorously with a shaker for 10 minutes. Opaque suspensions were obtained for the stabilizers, with the exception of Zn(acac)₂ (hazy solution) and Zn(stearate)₂ (soluble).

**Table I: Results of D.E.R.™ 592-A80 cured with Dicy**

| Zinc cmpd | Δ T_{d} (°C) | Δ T_{g} (°C) | Additive conc. (phr) | [Zn²⁺] (phr) | Maximum Improvement? |
|---|---|---|---|---|---|
| ZnO | 26 | 8 | 4 | 3.21 | Yes |
| Zn(OH)₂ | 26 | 7 | 6 | 3.95 | Until 6 phr |
| Zn acetylacetonate | 23 | 8 | 4 | <1 anhydr. basis | Not determined |
| ZnSnO₃ | 15 | 2 | 7 | 2 | Until 7 phr |
| Zn2SiO₄ | 23 | 0 | 8 | 4.67 | Until 8 phr |
| ZnMoO₄ | 21 | 6 | 8 | 2.31 | Until 8 phr |
| Zn Borate Hydrous | 16 | 5 | 5 | 1.5 | Yes |
| ZnF₂ hydrous | 18 | 4 | 7 | <4.43 | Yes |
| ZnCl₂ | 12 | -1 | 1 | 0.48 | Yes (with 2-MI) |
| Zn Borate Anhydrous | 6 | 5 | 7 | 2.46 | Yes |
| Zn dimethyl dithiocarbamate | 8 | 0 | 1 | 0.21 | Not determined |
| Zn phosphate | 6 | 0 | 5 | 2.54 | Yes |
| Zn stearate | 26 | | 10 | 1.03 | No; steady Td↑ & Tg↓ with Zn↑ |
| Zn 3,5-di-tert-butylsalicylate | 18 | | 4 | 0.464 | Not determined |
| Zn acetate | 28 | | 4 | 1.43 | Not determined |
| Zn bis-2-ethylhexanoate | 26 | | 4 | 0.744 | Not determined |
| ZnBr₂ | 6 | | 3 | 0.87 | yes |

Table II shows the results of adding various quantities of zinc oxide to the resin (Reference Examples).

**Table II: T_{d} of formulations (F) with "normal" ZnO**

| Products (phr) | F1 | F2 | F3 | F4 | F5 | F6 |
|---|---|---|---|---|---|---|
| D.E.R.™ 592-A80 | 100 | 100 | 100 | 100 | 100 | 100 |
| Dicy | 2.9 | 2.9 | 2.9 | 2.9 | 2.9 | 2.9 |
| 2-MI | 0.14 | 0.14 | 0.14. | 0.14 | 0.14 | 0.14 |
| ZnO | 0 | 1 | 2.5 | 5 | 7.5 | 10 |
| Gel time (s) | 275 | 248 | 254 | 259 | 249 | 260 |
| T_{d}(°C)(5% wt loss) | 294 | 303 | 317 | 314 | 317 | 317 |
| T_{d}(°C)(10% wt loss) | 297 | 306 | 326 | 324 | 325 | 325 |

Table III shows results using nano-ZnO (Reference Examples).

**Table III: T_{d} of Formulations with nano-ZnO**

| Products(phr) | F1 | F2 | F3 | F4 | F5 | F6 | F7 | F8 | F9 |
|---|---|---|---|---|---|---|---|---|---|
| D.E.R.™ 592-A80 | 100 | 100 | 100 | 100 | 100 | 100 | 100 | 100 | 100 |
| Dicy | 2.9 | 2.9 | 2.9 | 2.9 | 2.9 | 2.9 | 2.9 | 2.9 | 2.9 |
| 2-MI | 0.14 | 0.14 | 0.14 | 0.14 | 0.14 | 0.14 | 0.14 | 0.14 | 0.14 |
| Nano-ZnO (68 nm) | 0 | 1 | 2 | 3 | 4 | 5 | 6 | 8 | 10 |
| Gel time (s) | 259 | 272 | 267 | 259 | 267 | 274 | 278 | 276 | 274 |
| T_{d}(°C)(5% wt loss) | 294 | 306 | 316 | 319 | 320 | 318 | 315 | 317 | 318 |
| Td(°C)(10% wt loss) | 297 | 309 | 321 | 328 | 328 | 327 | 325 | 326 | 327 |

### Figure 1 shows a plot of phr of zinc oxide vs. the T_{d} for the nano-zinc oxide formulations.

Table IV shows results for the zinc stearate formulations (Reference Examples).

**Table IV: T_{d} of Formulations with Zinc Stearate**

| Products (phr) | F1 | F2 | F3 | F4 | F5 | F6 |
|---|---|---|---|---|---|---|
| D.E.R.™ 592-A80 | 100 | 100 | 100 | 100 | 100 | 100 |
| Dicy(8 wt% solids in DMF/PM) | 2.9 | 2.9 | 2.9 | 2.9 | 2.9 | 2.9 |
| 2-MI (10wt% solids in PM) | 0.14 | 0.14 | 0.14 | 0.14 | 0.14 | 0.14 |
| Zn stearate | 0 | 1 | 2.5 | 5 | 7.5 | 10 |
| Gel time (s) | 275 | 291 | 300 | 298 | 305 | 290 |
| T_{d}(°C)(5% wt loss) | 294 | 298 | 304 | 311 | 318 | 318 |
| Td(°C)(10% wt loss) | 297 | 300 | 306 | 313 | 321 | 325 |

Table V shows results with various metallic stabilizers (Reference Examples).

**Table V: Metallic Stabilizers**

| Additive | Phr | T_{d}(°C) (5% wt loss) |
|---|---|---|
| None (control) | 0 | 306 |
| Nano ZnO | 1 | 327(+21) |
| Lead carbonate | 2 | 311(+5) |
| In(III) oxide | 2 | 314(+8) |
| Lead (II) oxide | 2 | 312(+6) |
| Cu(II) oxide | 4 | 308(+2) |
| Indium tin oxide | 4 | 311(+5) |

### Example 2

A varnish was prepared as follows: a 125-part quantity of D.E.R.™ 539-A80 (80 weight percent solids in acetone, 100 parts of solids) and 37.5 parts of a solution of dicyandiamide (8 weight percent solids in DMF/PM=50 wt %/50 wt %) were mixed and shaken for 30 minutes to give a homogeneous solution. To this solution, 4 parts of zinc dimethyl-dithiocarbamate (ziram) powder was added and the mixture was shaken vigorously with a shaker for 10 minutes to give a clear transparent solution. The T_{d} of cured resins from this varnish is 309°C.

A 73-part quantity of D.E.N.™ 438-EK85 (85 weight percent solids in methyl ethyl ketone (MEK), 62 parts of solids), and 30 parts of a solution of dicyandiamide (same as in previous example) were mixed and shaken for 30 minutes to give a homogeneous solution. An 0.8-part quantity of ziram was then added and the mixture was shaken vigorously until all solids were dissolved to give a homogeneous and transparent varnish. The Td of cured resins from this varnish was 352°C.

### Example 3 (Reference Example)

This procedure was performed in a dry box and is as follows: To a 20 mL scintillation vial was added 1.02 grams of pre-dried phenolic novolac (ReziCure^{®} 3026, from SI Group, Inc.) and 5 mL of anhydrous tetrahydrofuran. The sample was allowed to stir until dissolution, upon which 1.5 mL of a 1.2M solution of diethyl zinc in hexanes was added dropwise with continuous stirring. A white solid formed after 1 minute and the reaction mixture was allowed to continue to stir an additional 90 minutes to ensure complete reaction. Solvent was removed under reduced pressure to yield 1.74 grams of a white solid (zinc phenate). Varnish formulation entailed mixing each component, shaking the resulting mixture for a period of time as indicated, and the varnish properties were tested. Three separate digestions (the amount of time given to ensure a reaction takes place) were tested and the results are shown in Table VI, below.

**Table VI: Varnish Formulations**

| | Solids Equivalents | | | | | |
|---|---|---|---|---|---|---|
| | Control | 2 hr digestion | | 6 day digestion | | 16 hr digestion |
| D.E.R.™ 592-A80 (g) | 100 | 100 | | 100 | | 100 |
| DICY (g) | 2.9 | 2.9 | | 2.9 | | 0 |
| 2-methylimidazole | 0.14 | 0.14 | | 0.14 | | 0.14 |
| Zn-phenate (13-14% Zn) | 0 | 7.5 | | 7.5 | | 28.5 |

| **Properties** | | **A** | **B** | **A** | **B** | |
|---|---|---|---|---|---|---|
| Gel Time (s) | 235 | 284 | 293 | 144 | 142 | 74 |
| T_{g}(1) (°C) | 163.6 | 151.7 | 153.5 | 148.3 | 146.2 | 154.7 |
| T_{g}(2) (°C) | 164.1 | 153.4 | 153.4 | 146.2 | 148.8 | 151.7 |
| T_{d}(°C) | 296.0 | 310.2 | 309.5 | 310.6 | 312.4 | 328.2 |

| | | | | | | |
|---|---|---|---|---|---|---|
| Note: 'A' and 'B' are duplicate samples. Tg(1) and Tg(2) are duplicate runs on one sample. | | | | | | |

## Claims

1. A composition comprising:
a) an epoxy resin;
b) a hardener; and
c) a stabilizer comprising a metal-containing compound, wherein said metal-containing compound is zinc dimethyldithiocarbamate,
wherein said composition is prepared from a halogen-containing compound.

2. A composition in accordance with claim 1 wherein said stabilizer is present in an amount in the range of from about 0.1 weight percent to about 20 weight percent, based on the total weight of said composition.

3. A composition in accordance with claim 1 further comprising a solvent in an amount in the range of from 0.5 to 95 wt%.

4. A composition in accordance with claim 1 further comprising inert fillers selected from the group consisting of talc, silica, alumina, and combinations thereof.

5. A composition in accordance with claim 1 wherein said halogen-containing compound is a bromine-containing compound.

6. A composition in accordance with claim 5 wherein said bromine-containing compound is a brominated polyphenol.

7. A composition in accordance with claim 6 wherein said brominated polyphenol is selected from the group consisting of tetrabromobisphenol-A (TBBA) and tetrabromobisphenol F.

8. A composition in accordance with claim 1 wherein said epoxy resin is produced by contacting a glycidyl ether with a bisphenol compound to form oxazolidinone moieties.

9. A composition in accordance with claim 8 wherein said epoxy resin is produced by contacting a glycidyl ether with a bisphenol compound and a polyisocyanate.

10. A composition in accordance with claim 8 wherein said bisphenol compound is bisphenol A.

11. A composition in accordance with claim 8 wherein said bisphenol compound is tetrabromobisphenol A.

12. A composition in accordance with claim 1 wherein said epoxy resin is selected from the group consisting of a phenolic resin, a benzoxazine resin, an aryl cyanate resin, an aryl triazine resin, a maleimide resin, and combinations of any two or more thereof.

13. A composition in accordance with claim 1 wherein said composition has at least one nucleophilic nitrogen source wherein a dative bond is formed between said metal and said nucleophilic nitrogen source.

14. A composition in accordance with claim 13 wherein said at least one nucleophilic nitrogen source is selected from the group consisting of an imidazole, an oxazolidinone, dicyandiamide and combinations thereof

## Patentansprüche

1. Zusammensetzung, umfassend:
a) ein Epoxidharz,
b) einen Härter und
c) einen eine metallhaltige Verbindung umfassenden Stabilisator, wobei die metallhaltige Verbindung Zink-Dimethyldithiocarbamat ist,
wobei die Zusammensetzung aus einer halogenhaltigen Verbindung hergestellt ist.

2. Zusammensetzung nach Anspruch 1, wobei der Stabilisator in einer Menge im Bereich von etwa 0,1 Gewichtsprozent bis etwa 20 Gewichtsprozent vorliegt, bezogen auf das Gesamtgewicht der Zusammensetzung.

3. Zusammensetzung nach Anspruch 1, ferner umfassend ein Lösemittel in einer Menge im Bereich von 0,5 bis 95 Gew.-%.

4. Zusammensetzung nach Anspruch 1, ferner umfassend inerte Füllstoffe, welche ausgewählt sind aus der Gruppe, bestehend aus Talk, Siliciumdioxid, Aluminiumoxid und Kombinationen davon.

5. Zusammensetzung nach Anspruch 1, wobei die halogenhaltige Verbindung eine bromhaltige Verbindung ist.

6. Zusammensetzung nach Anspruch 5, wobei die bromhaltige Verbindung bromiertes Polyphenol ist.

7. Zusammensetzung nach Anspruch 6, wobei das bromierte Polyphenol ausgewählt ist aus der Gruppe, bestehend aus Tetrabrombisphenol A (TBBA) und Tetrabrombisphenol F.

8. Zusammensetzung nach Anspruch 1, wobei das Epoxidharz hergestellt ist durch Kontaktieren eines Glycidylethers mit einer Bisphenolverbindung zur Bildung von Oxazolidinoneinheiten.

9. Zusammensetzung nach Anspruch 8, wobei das Epoxidharz hergestellt ist durch Kontaktieren eines Glycidylethers mit einer Bisphenolverbindung und einem Polyisocyanat.

10. Zusammensetzung nach Anspruch 8, wobei die Bisphenolverbindung Bisphenol A ist.

11. Zusammensetzung nach Anspruch 8, wobei die Bisphenolverbindung Tetrabrombis-phenol A ist.

12. Zusammensetzung nach Anspruch 1, wobei das Epoxidharz ausgewählt ist aus der Gruppe, bestehend aus einem Phenolharz, einem Benzoxazinharz, einem Arylcyanatharz, einem Aryltriazinharz, einem Maleimidharz und Kombinationen von zwei oder mehreren davon.

13. Zusammensetzung nach Anspruch 1, wobei die Zusammensetzung mindestens eine nukleophile Stickstoffquelle aufweist, wobei eine koordinative Bindung zwischen dem Metall und der nukleophilen Stickstoffquelle gebildet ist.

14. Zusammensetzung nach Anspruch 13, wobei die mindestens eine nukleophile Stickstoffquelle ausgewählt ist aus der Gruppe, bestehend aus einem Imidazol, einem Oxazolidinon, Dicyandiamid und Kombinationen davon.

## Revendications

1. Composition comprenant :
a) une résine époxy ;
b) un durcisseur ; et
c) un stabilisant comprenant un composé contenant un métal, dans lequel ledit composé contenant un métal est un diméthyldithiocarbamate de zinc,
dans laquelle ladite composition est préparée à partir d'un composé contenant un halogène.

2. Composition selon la revendication 1 dans laquelle ledit stabilisant est présent en une quantité dans la plage d'environ 0,1 à environ 20 % en poids, sur la base du poids total de ladite composition.

3. Composition selon la revendication 1 comprenant en outre un solvant en une quantité dans la plage de 0,5 à 95 % en poids.

4. Composition selon la revendication 1 comprenant en outre des charges inertes choisies dans le groupe constitué par le talc, la silice, l'alumine, et leurs combinaisons.

5. Composition selon la revendication 1 dans laquelle ledit composé contenant un halogène est un composé contenant du brome.

6. Composition selon la revendication 5 dans laquelle ledit composé contenant du brome est un polyphénol bromé.

7. Composition selon la revendication 6 dans laquelle ledit polyphénol bromé est choisi dans le groupe constitué par le tétrabromobisphénol-A (TBBA) et le tétrabromobisphénol-F.

8. Composition selon la revendication 1 dans laquelle ladite résine époxy est produite par mise en contact d'un éther glycidylique avec un composé de bisphénol pour former des fragments oxazolidinone.

9. Composition selon la revendication 8 dans laquelle ladite résine époxy est produite par mise en contact d'un éther glycidylique avec un composé de bisphénol et un polyisocyanate.

10. Composition selon la revendication 8 dans laquelle ledit composé de bisphénol est un bisphénol-A.

11. Composition selon la revendication 8 dans laquelle ledit composé de bisphénol est un tétrabromobisphénol-A.

12. Composition selon la revendication 1 dans laquelle ladite résine époxy est choisie dans le groupe constitué par une résine phénolique, une résine benzoxazine, une résine cyanate d'aryle, une résine triazine d'aryle, une résine maléimide, et les combinaisons de deux quelconques d'entre elles ou plus.

13. Composition selon la revendication 1 dans laquelle ladite composition contient au moins une source d'azote nucléophile, dans laquelle une liaison dative est formée entre ledit métal et ladite source d'azote nucléophile.

14. Composition selon la revendication 13 dans laquelle ladite au moins source d'azote nucléophile est choisie dans le groupe constitué par un imidazole, une oxazolidinone, un dicyandiamide et leurs combinaisons.
